# EUROPÄISCHE PATENTSCHRIFT

(11) **EP 1 519 072 B1**
(45) Veröffentlichungstag und Bekanntmachung des Hinweises auf die Patenterteilung: **20.02.2008**
(21) Anmeldenummer: 04104629.3
(22) Anmeldetag: 23.09.2004
(51) Int. Cl.: F16F 1/02

(54) **Rohrfeder für Aktor**
Tubular spring for actuators
Ressort tubulaire pour un actionneur

(30) Priorität: 25.09.2003 DE 10344621
(43) Veröffentlichungstag der Anmeldung: 30.03.2005
(73) Patentinhaber: ROBERT BOSCH GMBH, 70442 Stuttgart (DE)
(72) Erfinder: Uhlmann, Dietmar, 71404, Korb (DE)
(74) Vertreter: Körfer, Thomas

(56) Entgegenhaltungen:
- WO-A-00/08353
- DE-A- 10 140 196

## Beschreibung

### Stand der Technik

Die Erfindung geht aus von einer Rohrfeder für einen Aktor nach der Gattung des Hauptanspruchs.

Üblicherweise werden piezoelektrische oder magnetostriktive Aktoren zur Betätigung von Brennstoffeinspritzventilen für Brennstoffeinspritzanlagen von Brennkraftmaschinen zur Vermeidung von Zug- und Scherkräften durch eine Feder vorgespannt. Gewöhnlich wird zur Erzeugung der Vorspannung die auch bei geschlossenem Brennstoffeinspritzventil vorhandene Restspannung der Rückstellfeder des Brennstoffeinspritzventils genutzt.

Beispielsweise ist aus der DE 199 51 012 A1 ein Aktor, insbesondere zur Betätigung von Brennstoffeinspritzventilen für Brennstoffeinspritzanlagen von Brennkraftmaschinen, bekannt, welcher mehrere gestapelt angeordnete Schichten aus einem piezoelektrischen oder magnetostriktiven Material aufweist. Der Aktor wird durch einen in einer zentralen Ausnehmung angeordneten Zuganker mittels gegenläufiger Gewinde vorgespannt. Die Fixierung und Kraftübertragung erfolgt über eine Deckplatte und eine Bodenplatte.

Nachteilig an dieser Bauform ist dabei insbesondere die Notwendigkeit, den Stapelaktor hohl zu gestalten, um den Zuganker in der Ausnehmung unterbringen zu können. Dadurch wird der Aktor noch beschädigungsanfälliger bei Vormontage und Montage.

Weiterhin ist aus der WO 99/08330 A1 ein piezoelektrischer Aktor bekannt, der in eine Federhülse eingeschoben und vorgespannt mit zwei Enden der Federhülse kraft- und/oder formschlüssig verbunden wird. Dadurch wird eine Baueinheit hergestellt, bei der die Vorspannkraft des piezoelektrischen Aktors dauerhaft festgelegt ist.

Nachteilig an dieser Art Federn ist insbesondere, daß Querkräfte durch das Verschweißen entstehen, die zu einer ungleichmäßigen Lastverteilung führen und damit zu Störungen beim Betrieb des Aktors bzw. sogar zu dessen Zerstörung führen können.

Das Schweißen verursacht eine in der Regel unerwünschte Gefügeänderung des Hohlkörpers in unmittelbarer Nähe der Schweißnaht. Ein weiteres Problem besteht darin, daß Schweißspritzer und Schweißperlen sowie das Einsinken der Schweißnaht (sog. Nahteinfall) an Beginn und Ende der Schweißnaht entstehen und daraus eine Kerbwirkung und Spannungserhöhung resultiert.

Eine aus der WO 00/08353 A1 bekannte Aktoreinheit weist einen elastisch ausgebildeten Hohlkörper auf, in dem ein piezoelektrischer Aktor vorgespannt ist, wobei der Hohlkörper mit Ausnehmungen versehen ist, die knochenförmig ausgebildet sind und quer zur Hohlkörperachse verlaufen.

### Vorteile der Erfindung

Die erfindungsgemäße Rohrfeder für einen Aktor mit den Merkmalen des Hauptanspruchs hat demgegenüber den Vorteil, daß durch eine geeignete Ausgestaltung der Rohrfeder mit Ausnehmungen und Stegen eine über den gesamten Umfang der Rohrfeder konstante Lastaufnahme auch ohne Verschweißung der Längsseiten ermöglicht wird. Dieser Vorteil wird erfindungsgemäß dadurch erreicht, daß die Stege je nach ihrer Position unterschiedliche Abstände voneinander haben.

Durch die in den Unteransprüchen aufgeführten Maßnahmen sind vorteilhafte Weiterbildungen und Verbesserungen der im Hauptanspruch angegebenen Rohrfeder möglich.

Vorteilhafterweise sind dabei die Stege im Bereich der Längsseiten halbiert, so daß nach dem auf Stoß legen der Längsseiten die Stoßkante in einem Belastungstal liegt.

Insbesondere sind die Abstände zwischen Reihen mit gerader Numerierung und ungerader Numerierung unterschiedlich.

Zudem ist vorteilhaft, daß die Ausnehmungen zweier äußerer Reihen im Bereich der Längsseiten verlängert gegenüber den übrigen Ausnehmungen sind.

Die Ausnehmungen sind unabhängig von ihrer Länge immer gleich geformt und in einfacher Weise mit einem Stanzwerkzeug herstellbar.

### Zeichnung

Ein Ausführungsbeispiel der Erfindung ist in der Zeichnung vereinfacht dargestellt und in der nachfolgenden Beschreibung näher erläutert. Es zeigen:
- Fig. 1: eine stark schematisierte Darstellung eines für die Bestückung mit einer erfindungsgemäßen Rohrfeder geeigneten Brennstoffeinspritzventils;
- Fig. 2: ein Diagramm der Lastverteilung einer herkömmlichen und einer erfindungsgemäß ausgestalteten Rohrfeder unter Bezugnahme auf eine in
- Fig. 3: dargestellte, abgerollte Darstellung einer erfindungsgemäß ausgestalteten Rohrfeder;
- Fig. 4A: eine schematische Darstellung einer erfindungsgemäß ausgestalteten Rohrfeder in einer Gesamtdarstellung und in
- Fig. 4B: in einer ausschnittsweisen Darstellung; und
- Fig. 5A: eine schematischen Darstellung einer erfindungsgemäß ausgestalteten und fertig gerollten unverschweißten Rohrfeder in einer Gesamtdarstellung und in
- Fig. 5B: in einer ausschnittsweisen Darstellung.

### Beschreibung des Ausführungsbeispiels

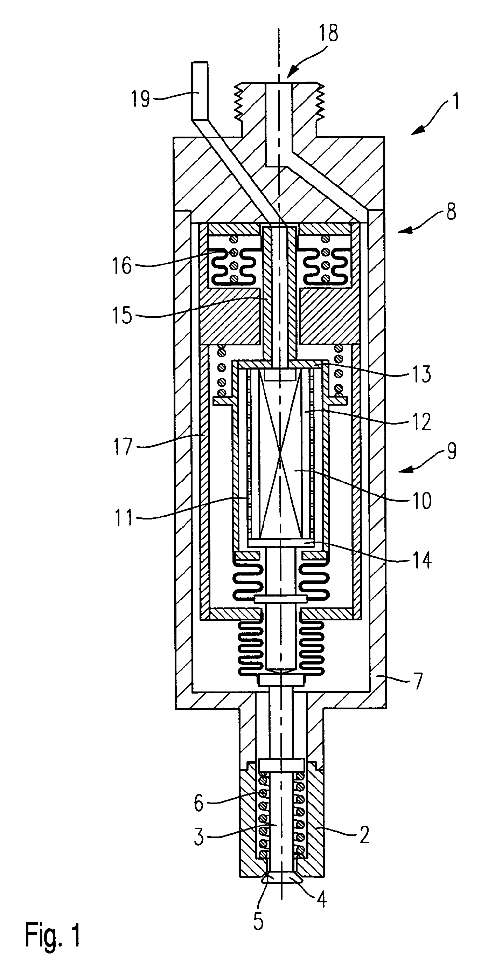

Fig. 1 zeigt zur besseren Verständlichkeit der Erfindung in einer stark schematisierten Darstellung ein zur Bestückung mit einer erfindungsgemäß ausgestalteten Rohrfeder geeignetes Brennstoffeinspritzventil.

Das in Fig. 1 dargestellte Brennstoffeinspritzventil 1 ist insbesondere als Brennstoffeinspritzventil 1 zum direkten Einspritzen von Brennstoff in einen nicht näher dargestellten Brennraum einer Brennkraftmaschine geeignet.

Das Brennstoffeinspritzventil 1 umfaßt einen Düsenkörper 2, in dem eine Ventilnadel 3 geführt ist. Diese weist an einem abströmseitigen Ende einen Ventilschließkörper 4 auf, welcher mit einer Ventilsitzfläche 5 einen Dichtsitz bildet. Das Brennstoffeinspritzventil 1 ist als nach außen öffnendes Brennstoffeinspritzventil 1 ausgebildet. Eine im Düsenkörper 2 angeordnete Rückstellfeder 6 beaufschlagt die Ventilnadel 3 so, daß das Brennstoffeinspritzventil 1 in der Ruhephase geschlossen gehalten bzw. die Ventilnadel 3 nach der Öffnungsphase in ihre Ruhestellung zurückgestellt wird.

Der Düsenkörper 2 mündet in ein Gehäuse 7 ein, in welchem eine hydraulische Ausgleichs-Aufhängung 8 und ein Aktormodul 9 angeordnet sind.

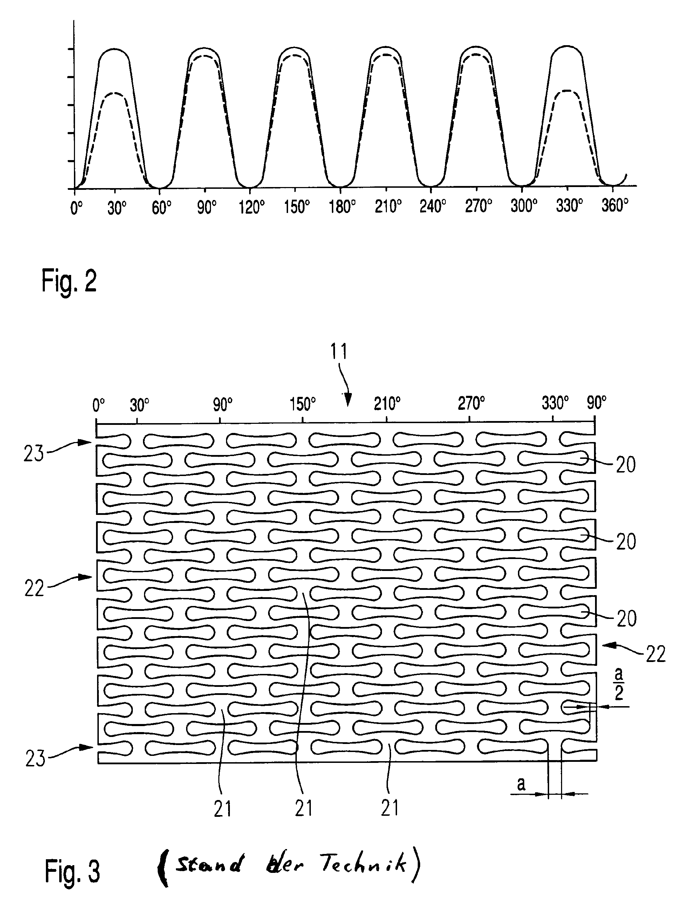

Das Aktormodul 9 umfaßt einen vorzugsweise piezoelektrischen Stapelaktor 10, welcher durch eine erfindungsgemäß ausgestaltete Rohrfeder 11 zum Schutz vor Scherkräften vorgespannt wird. Der Aktor 10 ist im vorliegenden Ausführungsbeispiel zusätzlich durch eine Umspritzung 12 geschützt. Der Aktor 10 weist einen Aktorfuß 13 und einen Aktorkopf 14 auf, welche mit der Rohrfeder 11 beispielsweise verschweißt sind. Die Rohrfeder 11 sowie die Bauteile des Aktors 10 werden weiter unten unter Bezugnahme auf die Fig. 2 bis 5 näher beschrieben.

Die hydraulische Ausgleichs-Aufhängung 8, welche zuströmseitig des Aktormoduls 9 angeordnet ist, umfaßt einen Kolben 15, welcher durch eine Kopplerfeder 16 gegenüber dem Gehäuse 7 vorgespannt ist.

Der Koppler 8 und das Aktormodul 9 sind in einem Aktorgehäuse 17 gekapselt. Dieses wird von dem zentral über einen Zulaufstutzen 18 zugeführten Brennstoff umströmt, welcher durch das Gehäuse 7 sowie durch den Düsenkörper 2 zum Dichtsitz strömt. Das Brennstoffeinspritzventil 1 ist über einen elektrischen Steckkontakt 19 betätigbar.

Um bei der Montage sowie beim Betrieb des Aktors 10 sicherzustellen, daß Scherkräfte, welche zur Zerstörung des Aktors 10 führen können, vermieden werden, ist der Aktor 10 in der Rohrfeder 11 gekapselt. Diese spannt den Aktor 10 vor, so daß dieser durch die auf ihn wirkenden ausschließlich axialen Kräfte stabilisiert wird. Weiterhin kann über die geeignete Wahl der Federkonstanten der Rohrfeder 11 ein progressives Ansprechverhalten des Aktors 10 ermöglicht werden.

Bekannte Rohrfedern 11 werden aus einer Platine ausgestanzt, zu einem Rohr gebogen und an einer axialen Längsseite verschweißt. Nachteilig an diesem Herstellungsverfahren ist dabei vor allem, daß durch die Schweißnaht eine Verspannung der Rohrfeder 11 nicht zu vermeiden ist. Die Verspannung führt zu einer Verfälschung des Federverhaltens und zu Querkräften auf den Aktor 10, welcher dadurch zerstört werden kann.

Andererseits ist es mit den herkömmlichen Federgeometrien nicht möglich, eine konstante Lastaufnahme über den Umfang der Rohrfeder 11 zu erzeugen, wenn die Rohrfeder 11 an ihrer Längsseite nicht verschweißt wird. In der Folge treten wiederum Verspannungen und Querkräfte auf. In Fig. 2 ist zur Illustration ein Diagramm dargestellt, welches mit einer durchgezogenen Linie die Lastverteilung einer verschweißten Rohrfeder 11 und mit einer gestrichelten Linie die Lastverteilung einer unverschweißten Rohrfeder 11 darstellt. Die unverschweißte Rohrfeder 11 weist unter Zug an der Stoßkante einen Krafteinbruch auf, welcher zu einer Verfälschung des Federverhaltens führt.

Eine erfindungsgemäß ausgestaltete Rohrfeder 11 weist eine über den gesamten Umfang konstante Lastaufnahme auf, ohne daß die Federgeometrie kostenaufwendig geändert werden muß.

Ein Ausführungsbeispiel einer bekannten Rohrfeder (Fig. 3) und einer erfindungsgemäß ausgestalteten Rohrfeder 11 ist im Folgenden unter Bezugnahme auf die Fig. 3 bis 5 näher beschrieben.

Fig. 3 zeigt eine abgerollte Darstellung einer Rohrfeder 11, welche zur Vermeidung der oben genannten Verfälschungen des Federverhaltens einerseits unverschweißt, andererseits aber so gestaltet ist, daß der Krafteinbruch in der Lastaufnahme an der unverschweißten Längsseite vermieden wird.

Die Rohrfeder 11 weist dabei Ausnehmungen 20 auf, welche sich jeweils mit Stegen 21 abwechseln. Die Stege 21 weisen dabei jeweils die gleiche Breite a auf. Durch die achtförmige Form der Ausnehmungen 20 ist die axiale Elastizität der Rohrfeder 11 gewährleistet. Die achtförmige Form der Ausnehmungen 20 ist zugleich der Ansatzpunkt für die Vermeidung des Krafteinbruchs bei der Lastaufnahme. Die Rohrfeder 11 wird durch entsprechendes Ausstanzen so hergestellt, daß die die Ausnehmungen 20 trennenden Stege 21 im Bereich von Längskanten 22 der Rohrfeder 11 genau auf der Hälfte der Breite a, also auf a/2, bemessen sind. Dadurch ergibt sich nach dem Zusammenbiegen der Rohrfeder 11 mit den Längskanten 22 auf Stoß auch an den Längskanten 22 die Summe a/2 + a/2 = a für die Breite der Stege 21.

Umgekehrt sind in zwei äußeren Reihen 23 die Ausnehmungen 20 ebenfalls genau mittig angeschnitten, so daß nach dem Zusammenbiegen der Rohrfeder 11 die Ausnehmungen 20 im Bereich der auf Stoß stehenden Längskanten 22 wiederum symmetrisch ausgebildet sind. Dadurch kann sichergestellt werden, daß die Kräfte auf die Rohrfeder 11 in Umfangsrichtung auch an den auf Stoß liegenden Längskanten 22 gleich sind.

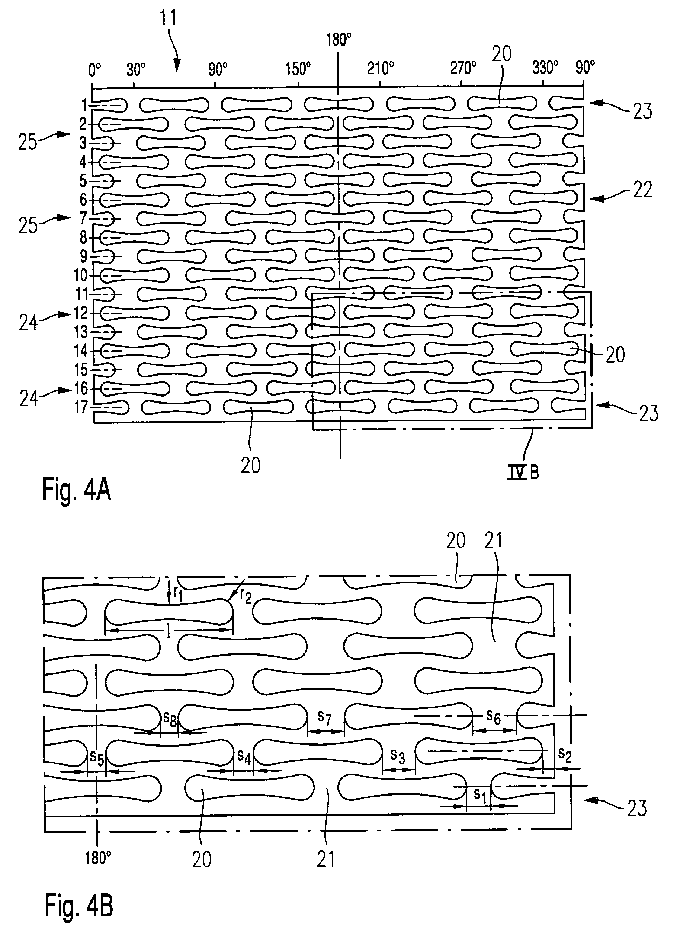

Die Maßnahme bewirkt, daß die der 0°-Position zugeordneten auf Stoß liegenden Längskanten 22 lastmäßig in ein Belastungstal gelegt werden, wie in Fig. 2 ersichtlich. Damit wird der Traganteil bei 30° und 330° in Umfangsrichtung der Rohrfeder 11 auf ca. 70% des Traganteils der übrigen tragenden Umfangspositionen bei 90°, 150°, 180°, 210° und 270° jeweils an der Position der Stege 21 erhöht. Da trotzdem noch Inhomogenitäten bei 30° und 330° auftreten, sind weitere Maßnahmen vorgesehen, die in Fig. 4A und 4B näher dargestellt sind.

Fig. 4A zeigt dabei die Rohrfeder 11 in gleicher Darstellung wie in Fig. 3 abgerollt in einer Gesamtansicht. Fig. 4B stellt den in Fig. 4A mit IVB gekennzeichneten Bereich vergrößert dar.

Die Rohrfeder 11 gemäß dem in Fig. 4A dargestellten Ausführungsbeispiel weist insgesamt siebzehn Reihen von Ausnehmungen 20 auf.

Zusätzlich zu der in Fig. 3 beschriebenen Maßnahme werden nun die Abstände der Stege 21 und die Geometrie der Aussparungen 20 modifiziert. Dabei werden in den zwei äußeren Reihen 23 Abstände s₁ der Stege 21 unter Beibehaltung der Lastpositionen in Abständen von 60° in Umfangsrichtung beibehalten. In Reihen 24 mit gerader Numerierung (Reihen 2, 4, 6,...) werden Abstände s₂, s₃, s₄ und s₅ gewählt, während in Reihen 25 mit ungerader Numerierung (Reihen 3, 5, 7,...) Abstände s₆, s₇ und s₈ gewählt werden. Durch diese Maßnahme wird der Traganteil an den Umfangspositionen 30° und 330° an die restlichen tragenden Umfangspositionen angeglichen, indem die Abstände s₁ bis s₈ entsprechend gewählt werden. Es ergeben sich sechs gleich stark beanspruchte Umfangspositionen bei 30°, 90°, 150°, 210°, 270° und 330°.

Die Form der Ausnehmungen 20, welche durch Krümmungsradien r₁ und r₂ beschrieben ist, bleibt dabei unabhängig von einer Länge 1 der Ausnehmungen 20 voneinander gleich. Die Länge 1 variiert je nach der Breite s der Stege 21 oder umgekehrt. Die Geometrie der Ausnehmungen 20 ist somit jeweils gleich, während die Länge 1 der Ausnehmungen 20 mit einer geeigneten Stanzform, welche beispielsweise in Form einer halben Ausnehmung 20 ausgebildet ist, beliebig gestaltet werden kann.

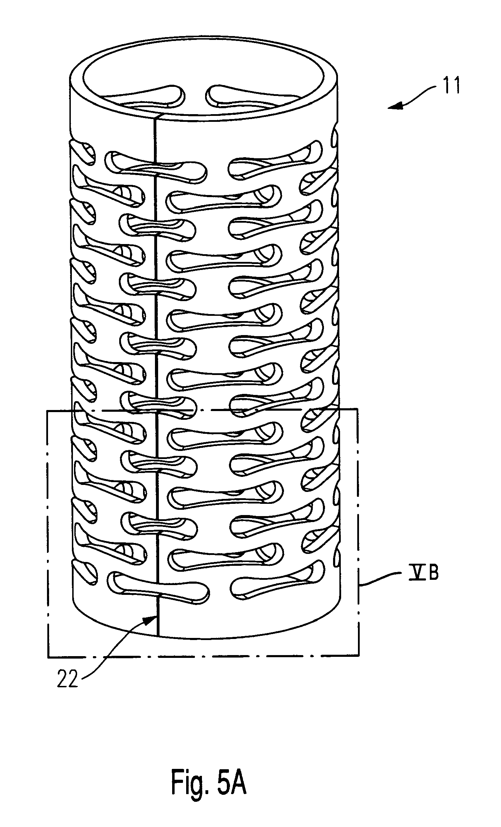

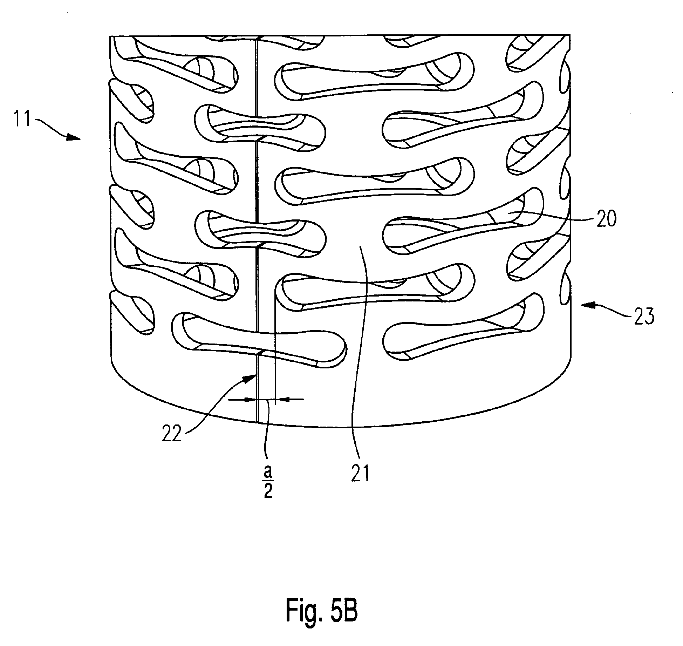

Fig. 5A und 5B zeigen in perspektivischer Darstellung die fertig zusammengebogene Rohrfeder 11. Wie bereits weiter oben beschrieben, sind die auf Stoß aneinandergelegten Längsseiten 22 nicht miteinander verschweißt. Die Abstände zwischen den Längsseiten 22 und den benachbarten Ausnehmungen 20 betragen a/2.

Die Ausnehmungen 20 der beiden äußeren Reihen 23 sind gegenüber den übrigen Ausnehmungen 20 verlängert, wie insbesondere in Fig. 5B erkennbar. Die Breiten der Stege 21 sind ebenfalls als unterschiedlich groß erkennbar.

Die Erfindung ist nicht auf das dargestellte Ausführungsbeispiel beschränkt und insbesondere bei einer Vielzahl von Bauweisen von Brennstoffeinspritzventilen anwendbar. Auch sind alle Merkmale des Ausführungsbeispiels beliebig miteinander kombinierbar.

## Patentansprüche

1. Rohrfeder (11) für einen piezoelektrischen oder magnetostriktiven Aktor (10), welcher insbesondere zur Betätigung eines Brennstoffeinspritzventils (1) für Brennstoffeinspritzanlagen von Brennkraftmaschinen dient, mit mehreren Reihen (23, 24, 25) von Ausnehmungen (20) und dazwischenliegenden Stegen (21),
wobei die Ausnehmungen (20) und/oder Stege (21) der Rohrfeder (11) so ausgestaltet sind, dass die Rohrfeder (11) ohne Verschweißung an ihren auf Stoß aneinanderliegenden Längsseiten (22) eine über den Umfang der Rohrfeder (11) gleichmäßige Lastaufnahme aufweist
**dadurch gekennzeichnet,**
**dass** die Stege (21) zwischen den Ausnehmungen (20) je nach ihrer Position variable Breiten (s₁ bis s₈) aufweisen.

2. Rohrfeder nach Anspruch 1,
**dadurch gekennzeichnet,**
**dass** die Stege (21) zweier äußerer Reihen (23) von Ausnehmungen (20) so gestaltet sind, dass die Breite a der Stege (21) sich auf a/2 pro Längsseite (22) aufteilt.

3. Rohrfeder nach Anspruch 2,
**dadurch gekennzeichnet,**
**dass** eine Länge (1) der Ausnehmungen (20) in den zwei äußeren Reihen (23) größer ist als eine Länge (1) der Ausnehmungen (20) der übrigen Reihen (24, 25).

4. Rohrfeder nach Anspruch 3,
**dadurch gekennzeichnet,**
**dass** die Breiten der Stege (21) in geraden Reihen (24) (s₂ bis s₅) unterschiedlich sind.

5. Rohrfeder nach Anspruch 3,
**dadurch gekennzeichnet,**
**dass** die Breiten der Stege (21) in ungeraden Reihen (25) (s₆ bis s₈) unterschiedlich sind.

6. Rohrfeder nach einem der Ansprüche 1 bis 5,
**dadurch gekennzeichnet,**
**dass** die Ausnehmungen (20) ungefähr achtförmig ausgeformt sind.

7. Rohrfeder nach Anspruch 6,
**dadurch gekennzeichnet,**
**dass** die Ausnehmungen (20) durch zwei Krümmungsradien (r₁, r₂) **gekennzeichnet** sind.

8. Rohrfeder nach Anspruch 7,
**dadurch gekennzeichnet,**
**dass** die Länge (1) der Ausnehmungen (20) durch den ersten Krümmungsradius (r₁) bedingt ist.

9. Rohrfeder nach Anspruch 7 oder 8,
**dadurch gekennzeichnet,**
**dass** die Länge (1) der Ausnehmungen (20) unabhängig von dem zweiten Krümmungsradius (r₂) ist.

10. Rohrfeder nach einem der Ansprüche 1 bis 9,
**dadurch gekennzeichnet,**
**dass** die Ausnehmungen (20) durch Stanzen hergestellt sind.

## Claims

1. Tubular spring (11) for a piezoelectric or magnetostrictive actuator (10) which serves, in particular, for activating a fuel injection valve (1) for fuel injection systems of internal combustion engines, having a plurality of rows (23, 24, 25) of cutouts (20) and intermediate webs (21),
wherein the cutouts (20) and/or webs (21) of the tubular spring (11) are configured in such a way that the tubular spring (11) has, without welding on its longitudinal sides (22) which abut against one another, a load pickup which is uniform over the circumference of the tubular spring (11), **characterized in that** the webs (21) have variable widths (s₁ to s₈) between the cutouts (20) depending on the position of said webs (21).

2. Tubular spring according to Claim 1, **characterized in that** the webs (21) of two outer rows (23) of cutouts (20) are configured such that the width a of the webs (21) is apportioned as a/2 per longitudinal side (22).

3. Tubular spring according to Claim 2, **characterized in that** a length (1) of the cutouts (20) in the two outer rows (23) is greater than a length (1) of the cutouts (20) of the other rows (24, 25).

4. Tubular spring according to Claim 3, **characterized in that** the widths of the webs (21) are different in even rows (24) (s₂ to s₅).

5. Tubular spring according to Claim 3, **characterized in that** the widths of the webs (21) are different in odd rows (25) (s₆ to s₈).

6. Tubular spring according to one of Claims 1 to 5, **characterized in that** the cutouts (20) are formed approximately in the shape of a figure 8.

7. Tubular spring according to Claim 6, **characterized in that** the cutouts (20) are **characterized by** two curvature radii (r₁, r₂).

8. Tubular spring according to Claim 7, **characterized in that** the length (1) of the cutouts (20) is conditioned by the first curvature radius (r₁).

9. Tubular spring according to Claim 7 or 8, **characterized in that** the length (1) of the cutouts (20) is independent of the second curvature radius (r₂).

10. Tubular spring according to one of Claims 1 to 9, **characterized in that** the cutouts (20) are manufactured by punching.

## Revendications

1. Ressort tubulaire (11) pour un actionneur piézo-électrique ou magnétostrictif (10), notamment destiné à commander un injecteur de carburant (1) pour des installations d'injection de carburant de moteurs à combustion interne, comportant plusieurs rangées (23, 24, 25) de découpes (20) avec des entretoises (21) interposées,
les découpes (20) et/ou les entretoises (21) du ressort tubulaire (11) étant conçues pour que le ressort tubulaire (11) offre, sans soudage de ses côtés longitudinaux (22) appliqués l'un contre l'autre bout à bout, une capacité de charge régulière sur toute sa périphérie,
**caractérisé en ce que**
les entretoises (21) entre les découpes (20) ont des largeurs variables (s₁-s₈) en fonction de leur position.

2. Ressort tubulaire selon la revendication 1,
**caractérisé en ce que**
les entretoises (21) de deux rangées extérieures (23) de découpes (20) sont conçues pour que la largeur (a) des entretoises (21) se répartisse sur (a/2) par un côté longitudinal (22).

3. Ressort tubulaire selon la revendication 2,
**caractérisé en ce qu'**
une longueur (1) des découpes (20) dans les deux rangées extérieures (23) est supérieure à une longueur (1) des découpes (20) des autres rangées (24, 25).

4. Ressort tubulaire selon la revendication 3,
**caractérisé en ce que**
les largeurs des entretoises (21) des rangées paires (24) (s₂-s₅) sont différentes.

5. Ressort tubulaire selon la revendication 3,
**caractérisé en ce que**
les largeurs des entretoises (21) dans les rangées impaires (25) (s₆-s₈) sont différentes.

6. Ressort tubulaire selon l'une des revendications 1 à 5,
**caractérisé en ce que**
les découpes (20) ont sensiblement une forme de huit.

7. Ressort tubulaire selon la revendication 6,
**caractérisé en ce que**
les découpes (20) sont **caractérisées par** deux rayons de courbure (r₁, r₂).

8. Ressort tubulaire selon la revendication 7,
**caractérisé en ce que**
la longueur (1) des découpes (20) est conditionnée par le premier rayon de courbure (r₁).

9. Ressort tubulaire selon les revendications 7 ou 8,
**caractérisé en ce que**
la longueur (1) des découpes (20) est indépendante du second rayon de courbure (r₂).

10. Ressort tubulaire selon l'une des revendications 1 à 9,
**caractérisé en ce que**
les découpes (20) sont réalisées par emboutissage.
